# EUROPÄISCHE PATENTANMELDUNG

(11) **EP 1 172 855 A2**
(43) Veröffentlichungstag der Anmeldung: **16.01.2002**
(21) Anmeldenummer: 01114673.5
(22) Anmeldetag: 19.06.2001
(51) Int. Cl.: H01L 27/108, H01L 23/525, H01L 21/768

(54) **Integrierter Halbleiterspeicher mit Speicherzellen in mehreren Speicherzellenfeldern und Verfahren zur Reparatur eines solchen Speichers**

(30) Priorität: 13.07.2000 DE 10034062
(71) Anmelder: Infineon Technologies AG, 81669 München (DE)
(72) Erfinder: Hartmann, Udo, 81541 München (DE)
(74) Vertreter: Epping Hermann & Fischer

(57) **Zusammenfassung**

Ein integrierter Halbleiterspeicher weist Speicherzellen (MC, RMC) in jeweils mehreren Speicherzellenfeldern (31 bis 36, 41 bis 46) auf, die auf einem Halbleiterchip (10) jeweils in übereinander verlaufenden Ebenen (1 bis 6) angeordnet sind. Mehrere der Speicherzellen (MC, RMC) sind jeweils zu normalen Einheiten (B1, B2) und redundanten Einheiten (RB1, RB2) von Speicherzellen zum Ersetzen jeweils einer der normalen Einheiten (B1, B2) zusammengefaßt. Die normalen Einheiten (B1, B2) und die redundanten Einheiten (RB1, RB2) umfassen jeweils Speicherzellen von Speicherzellenfeldern mehrerer Ebenen (1 bis 6). Im Falle einer fehlerhaften Speicherzelle (MC1) wird die betreffende normale Einheit (B2) durch eine der redundanten Einheiten (RB2) ersetzt. Dadurch ist eine reduzierte Anzahl von programmierbaren Elementen zur Programmierung der redundanten Speicherzellen für eine Reparatur des Speichers ermöglicht.

## Beschreibung

Integrierter Halbleiterspeicher mit Speicherzellen in mehreren Speicherzellenfeldern und Verfahren zur Reparatur eines solchen Speichers

Die vorliegende Erfindung betrifft einen integrierten Halbleiterspeicher mit Speicherzellen, die jeweils in mehreren Speicherzellenfeldern angeordnet sind, bei dem die Speicherzellenfelder auf einem Halbleiterchip jeweils in übereinander verlaufenden Ebenen angeordnet sind, sowie ein Verfahren zur Reparatur eines solchen Speichers.

Integrierte Halbleiterspeicher, wie beispielsweise DRAM-Speicher, weisen im allgemeinen zur Reparatur fehlerhafter Speicherzellen eines Speicherzellenfeldes redundante Einheiten von Speicherzellen auf, die normale Einheiten von Speicherzellen mit defekten Speicherzellen adressenmäßig ersetzen können. Die Speicherzellen sind in dem Speicherzellenfeld üblicherweise zu Einheiten von einzelnen oder mehreren Zeilenleitungen und Spaltenleitungen beziehungsweise redundanten Zeilenleitungen und redundanten Spaltenleitungen zusammengefaßt.

Der integrierte Speicher wird beispielsweise mit einer externen Prüfeinrichtung geprüft und anschließend eine Programmierung der redundanten Elemente vorgenommen. Eine Redundanzschaltung weist dann programmierbare Elemente z.B. in Form von Laser-Fuses oder elektrisch programmierbaren Fuses auf, die zum Speichern der Adresse einer zu ersetzenden Einheit dienen. Sie sind meist in sogenannten Fuse-Bänken angeordnet und werden beispielsweise im Laufe des Herstellungsprozesses nach dem Test des Speichers mittels eines Laserstrahls beziehungsweise einer sogenannten Brennspannung programmiert. Im Betrieb des Speichers werden im Zuge eines Speicherzugriffs mittels einer entsprechenden Redundanzschaltung die zu ersetzenden normalen Einheiten durch die entsprechenden redundanten Einheiten adressenmäßig ersetzt.

Ein sogenannter MRAM-Speicher mit Speicherzellen mit magnetoresistivem Speichereffekt ist aus WO 99/14760 bekannt. Die Speicherzellen weisen zur Speicherung von Datensignalen in ihrem Zustand veränderbare ferromagnetische Schichten auf. Die Speicherzellen sind jeweils zwischen eine der Zeilenleitungen und eine der Spaltenleitungen geschaltet und mit der jeweiligen Spaltenleitung und Zeilenleitung elektrisch verbunden. Die Speicherzellen mit magnetoresistivem Speichereffekt sind dabei hochohmiger als die Zeilenleitungen und Spaltenleitungen. Die Spaltenleitungen sind zum Auslesen eines Datensignals einer ausgewählten Speicherzelle mit einem Leseverstärker verbunden.

Da bei einem derartigen MRAM-Speicher keine Auswahltransistoren vorhanden sind, die zum Auslesen oder Schreiben eines Datensignals die Speicherzellen abhängig von der Adressierung mit der jeweiligen Spaltenleitung verbinden, erhält man insbesondere Vorteile bei der geometrischen Anordnung der Speicherzellen. So können die Speicherzellen in unterschiedlichen Speicherzellenfeldern angeordnet werden, die auf dem Halbleiterchip jeweils in übereinander verlaufenden Ebenen angeordnet sind. Durch eine derartige gestapelte Anordnung der Speicherzellenfelder kann eine wesentliche Platzersparnis erreicht werden.

Wird die bei DRAM-Speichern bekannte Technik zur Reparatur eines Speichers auf einen derartigen MRAM-Speicher angewandt, so ist für jedes der einzelnen Speicherzellenfelder im allgemeinen eine Redundanzschaltung mit Fuse-Bänken vorzusehen zum Ersetzen von Speicherzellen des betreffenden Speicherzellenfeldes. Programmierbare Elemente wie Laser-Fuses können aus Gründen der Zugänglichkeit im allgemeinen nicht in einer gestapelten Anordnung vorgesehen werden. Das bedeutet, bei einer relativ hohen Anzahl von redundanten Einheiten von Speicherzellen für die einzelnen Speicherzellenfelder ist für einen Speicher mit nebeneinander angeordneten Fuse-Bänken im allgemeinen ein relativ hoher Platzbedarf notwendig, der die Platzersparnis der gestapelten Speicherzellenfelder wieder teilweise zunichte machen kann.

Die Aufgabe der vorliegenden Erfindung ist es, einen integrierten Halbleiterspeicher der eingangs genannten Art anzugeben, der normale Speicherzellen und redundante Speicherzellen aufweist, bei dem eine vergleichsweise platzsparende Schaltungsanordnung zur Programmierung der redundanten Speicherzellen für eine Reparatur des Speichers ermöglicht ist.

Weiterhin ist es Aufgabe der vorliegenden Erfindung, ein Verfahren zur Reparatur eines solchen Speichers anzugeben.

Die Aufgabe betreffend den integrierten Halbleiterspeicher wird gelöst durch einen integrierten Halbleiterspeicher der eingangs genannten Art, bei dem mehrere der Speicherzellen zu normalen Einheiten von Speicherzellen zusammengefaßt sind, bei dem mehrere der Speicherzellen zu redundanten Einheiten von Speicherzellen zum Ersetzen jeweils einer der normalen Einheiten zusammengefaßt sind, und bei dem die normalen Einheiten und die redundanten Einheiten jeweils Speicherzellen von Speicherzellenfeldern mehrerer Ebenen umfassen.

Die Aufgabe betreffend das Verfahren wird gelöst durch ein Verfahren zur Reparatur eines erfindungsgemäßen integrierten Halbleiterspeichers, bei dem die Speicherzellen der einzelnen Speicherzellenfelder auf Fehlerfreiheit geprüft werden, bei dem die Speicherzellen, die als fehlerhaft erkannt sind, durch redundante Speicherzellen ersetzt werden, und bei dem im Falle wenigstens einer als fehlerhaft erkannten Speicherzelle die betreffende normale Einheit, in der die als fehlerhaft erkannte Speicherzelle enthalten ist, durch eine der redundanten Einheiten ersetzt wird.

Die Erfindung ist auf beliebige integrierte Halbleiterspeicher anwendbar, die mehrere Speicherzellenfelder in jeweils übereinander verlaufenden Ebenen aufweisen. Eine derartige Anordnung ist vor allem bei MRAM-Speichern anwendbar. Ein solcher Speicher weist insbesondere Speicherzellen mit magnetoresistivem Speichereffekt auf, die jeweils zwischen eine von mehreren Spaltenleitungen und eine von mehreren Zeilenleitungen des jeweiligen Speicherzellenfeldes geschaltet sind.

Durch die Zusammenfassung von Speicherzellen in normale Einheiten beziehungsweise redundante Einheiten, die jeweils Speicherzellen in mehreren Ebenen umfassen, ist es möglich, die Anzahl von zu einer Programmierung notwendigen programmierbaren Elementen insgesamt zu reduzieren. Es ist beispielsweise nicht erforderlich, jeweils für ein Speicherzellenfeld eine eigene Fuse-Bank vorzusehen. Beispielsweise umfassen die normalen Einheiten und redundanten Einheiten jeweils Speicherzellen von vier übereinander angeordneten Speicherzellenfeldern. Es kann hier die Anzahl der vorzusehenden Fuse-Bänke um den Faktor 4 reduziert werden, da eine redundante Einheit Speicherzellen nicht nur eines Speicherzellenfeldes sondern von vier Speicherzellenfeldern umfaßt. Weist dabei eine der normalen Einheiten wenigstens eine fehlerhafte Speicherzelle auf, so wird die betreffende normale Einheit durch eine der redundanten Einheiten ersetzt. Es werden in dem Beispiel also Speicherzellen aller vier Speicherzellenfelder zusammen durch eine redundante Einheit ersetzt.

Die Erfindung bedient sich dabei der Erkenntnis, daß beispielsweise bei einem MRAM-Speicher, der eine gestapelte Anordnung seiner Speicherzellenfelder aufweist, insbesondere bei übereinander liegenden Speicherzellen gemeinsame Fehler zu erwarten sind. Das heißt, ist eine Speicherzelle eines Speicherzellenfeldes fehlerhaft, so ist mit einer bestimmten statistischen Wahrscheinlichkeit zu erwarten, daß die darunter beziehungsweise darüber liegende Speicherzelle ebenfalls fehlerhaft ist. Eine solche statistische Wahrscheinlichkeit kann dazu genutzt werden, bestimmte Einheiten von Speicherzellen zu definieren, in denen relativ häufige Fehlerkopplungen zu beobachten sind. Solche normale Einheiten werden erfindungsgemäß gemeinsam durch eine redundante Einheit repariert.

In einem fehlerbehafteten Speicherzellenfeld, in dem die Speicherzellen an je eine Zeilenleitung und Spaltenleitung angeschlossen sind, sind bei Auftreten mehrfacher Funktionsfehler meist signifikante Häufungen der Funktionsfehler entlang von Spaltenleitungen oder Zeilenleitungen feststellbar. So ist beispielsweise bei einem defekten Leseverstärker die an diesen Leseverstärker angeschlossene Spaltenleitung in ihrer Funktionsfähigkeit betroffen und damit die gesamten, daran angeschlossenen Speicherzellen. Ähnliche Effekte von Fehlerkopplungen sind auch bei dreidimensionalen Anordnungen von Speicherzellenfeldern beobachtbar. So sind insbesondere herstellungsbedingte Effekte denkbar, durch die besonders übereinander liegende Speicherzellen gemeinsam betroffen sind (z.B. Ablagerungen von Partikeln auf der Oberfläche des Halbleiterchips). Durch die Berücksichtigung von statistischen Fehlerkopplungen kann also die Anzahl von vorzusehenden Fuse-Bänken um einen bestimmten Faktor reduziert werden, ohne daß die Reparaturmöglichkeiten um denselben Faktor eingeschränkt werden.

In einer Ausführungsform des integrierten Speichers umfassen eine der normalen Einheiten und eine der redundanten Einheiten jeweils Speicherzellen von Speicherzellenfeldern, die jeweils in gleichen Ebenen angeordnet sind. Dadurch ist insbesondere gewährleistet, daß die redundanten Speicherzellen physikalisch gleich angeordnet sind wie die zu ersetzenden normalen Speicherzellen. Dadurch ist eine "lagerichtige" Reparatur ermöglicht.

In einer Ausführungsform einer derartigen Reparatur wird eine Speicherzelle beispielsweise eines ersten Speicherzellenfeldes durch eine redundante Speicherzelle eines der Speicherzellenfelder ersetzt, das in der gleichen Ebene wie das erste Speicherzellenfeld angeordnet ist. Das heißt, Speicherzellen einer bestimmten Ebene werden nur durch redundante Speicherzellen der gleichen Ebene ersetzt.

Weitere vorteilhafte Aus- und Weiterbildungen sind in Unteransprüchen gekennzeichnet.

Die Erfindung wird nachfolgend anhand der in der Zeichnung dargestellten Figuren näher erläutert. Es zeigen:
- Figur 1: ein Ausführungsbeispiel eines MRAM-Speichers;
- Figur 2: ein Ausführungsbeispiel eines MRAM-Speichers mit Speicherzellenfeldern in gestapelter Anordnung;
- Figur 3: eine Ausführungsform einer Redundanzschaltung.

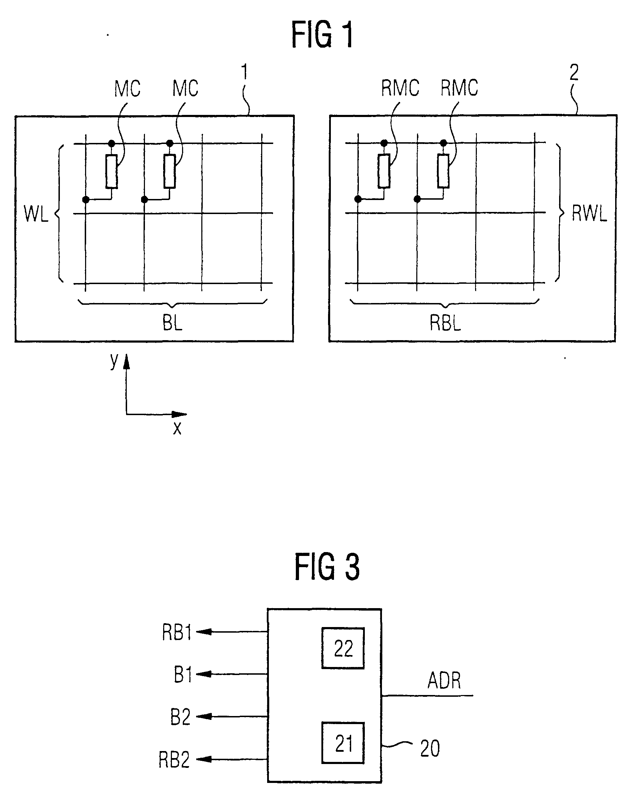

Figur 1 zeigt ein Ausführungsbeispiel eines MRAM-Speichers mit Speicherzellen mit magnetoresistivem Speichereffekt. Als Speicherzellen sind alle bekannten GMR-/TMR-Elemente geeignet, sofern sie hochohmiger sind als die Spaltenleitungen und die Zeilenleitungen. Der Speicher weist hier eine beispielhafte Anzahl von Zeilenleitungen und Spaltenleitungen auf. Die Speicherzellen MC, die in einem zweidimensionalen matrixförmigen Speicherzellenfeld 1 angeordnet sind, sind jeweils zwischen eine der Spaltenleitungen BL und eine der Zeilenleitungen WL geschaltet. Der Speicher weist weiterhin ein matrixförmiges Speicherzellenfeld 2 auf, das redundante magnetoresistive Speicherzellen RMC zum Ersetzen von normalen Speicherzellen MC enthält. Die redundanten Speicherzellen RMC sind ähnlich wie die Speicherzellen MC jeweils zwischen eine der redundanten Zeilenleitungen RWL und eine der redundanten Spaltenleitungen RBL geschaltet.

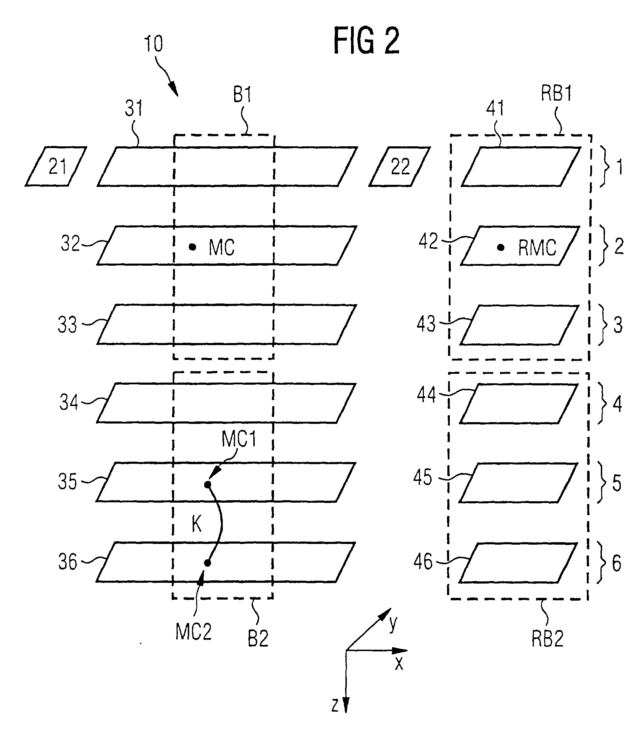

Figur 2 zeigt grob schematisch eine Anordnung eines MRAM-Speichers, der Speicherzellenfelder in gestapelter Anordnung aufweist. Die Speicherzellenfelder 31 bis 36 weisen dabei einen Aufbau wie das Speicherzellenfeld 1 aus Figur 1 auf. Die Speicherzellenfelder 41 bis 46 weisen einen Aufbau wie das Speicherzellenfeld 2 aus Figur 1 auf. Die Speicherzellenfelder 31 bis 36 und 41 bis 46 sind auf dem Halbleiterchip 10 jeweils in übereinander verlaufenden Ebenen 1 bis 6 angeordnet. Innerhalb der Speicherzellenfelder 31 bis 33 ist eine bestimmte Anzahl von Speicherzellen MC zu einer normalen Einheit B1 von Speicherzellen zusammengefaßt. Ähnlich dazu sind Speicherzellen MC der Speicherzellenfelder 34 bis 36 zu einer Einheit B2 zusammengefaßt. Redundante Speicherzellen RMC der Speicherzellenfelder 41 bis 43 sind zu einer redundanten Einheit RB1 von Speicherzellen zum Ersetzen jeweils einer der normalen Einheiten B1 oder B2 zusammengefaßt. Ähnlich dazu sind die Speicherzellen RMC der Speicherzellenfelder 44 bis 46 zu einer redundanten Einheit RB2 zusammengefaßt.

Die zweidimensionalen Speicherzellenfelder der Figuren 1 und 2 erstrecken sich dabei in x-Richtung und y-Richtung eines kartesischen Koordinatensystems. Die Speicherzellenfelder gemäß Figur 2 sind in dazu senkrechter z-Richtung des Koordinatensystems übereinander gestapelt.

Zur Überprüfung der Speicherzellen MC des Speichers hinsichtlich deren Funktionsfähigkeit wird dieser einem Speicherzellentest unterzogen. Während eines solchen Testbetriebs zur Überprüfung der Speicherzellen werden beispielsweise Testdaten in jede einzelne Speicherzelle eingeschrieben und wieder ausgelesen. Ein Vergleich zwischen den eingeschriebenen und wieder ausgelesenen Daten gibt Aufschluß darüber, ob ein Funktionsfehler vorliegt oder nicht. Bei dem vorliegenden Speicher ist insbesondere eine statistische Wahrscheinlichkeit gegeben, daß bei übereinander liegenden Speicherzellen Fehlerkopplungen auftreten. Im Beispiel nach Figur 2 ist dies anhand der Speicherzellen MC1 und MC2 der Speicherzellenfelder 35 und 36 anhand einer Kopplung K gezeigt. Die Speicherzelle MC1 ist im Funktionstest als fehlerhaft erkannt, ebenso ist die darunter liegende Speicherzelle MC2 defekt. Eine Reparatur wird bereits durch das Detektieren der fehlerhaften Speicherzelle MC1 oder MC2 ausgelöst.

Zum Ersatz der normalen Einheit B2 ist eine Fuse-Bank 21 vorgesehen. Diese weist beispielsweise programmierbare Elemente in Form von Laser-Fuses auf, die zum Speichern der Adresse der zu ersetzenden Einheit B2 dienen. Zum Ersatz der fehlerhaften Speicherzellen MC1 und MC2 der Speicherzellenfelder 35 und 36 ist also nur eine Fuse-Bank 21 notwendig. Durch die Zusammenfassung von übereinander liegenden Speicherzellen ist also eine platzsparende Anordnung von Fuse-Bänken ermöglicht, da deren Anzahl reduziert ist. Für den Fall, daß die Einheit B1 ebenfalls zu ersetzen ist, ist eine weitere Fuse-Bank 22 zur Speicherung deren Adresse vorgesehen. Die Fuse-Bänke 21 und 22 können nicht übereinander gestapelt werden, da diese insbesondere zur Zuführung eines Laserstrahls von oben zugänglich sein müssen. Insgesamt sind für sechs Speicherzellenfelder als nur zwei Fuse-Bänke zur Programmierung der Reparaturinformation notwendig.

Zur Reparatur der fehlerhaften Speicherzelle MC1 wird die betreffende Einheit B2 vorteilhaft durch die redundante Einheit RB2 ersetzt. Da die redundanten Speicherzellen im Vergleich zu den zu ersetzenden Speicherzellen physikalisch in den gleichen Ebenen angeordnet sind, ist eine "lagerichtige" Reparatur gewährleistet. Dazu wird die fehlerhafte Speicherzelle MC1 des Speicherzellenfeldes 35 durch eine entsprechende Speicherzelle RMC des Speicherzellenfeldes 45 ersetzt. Dabei befinden sich die Speicherzellenfelder 35 und 45 in der gleichen Ebene 5. Ebenso sind die Speicherzellenfelder 34 und 44 in einer gleichen Ebene 4, die Speicherzellenfelder 36 und 46 in einer gemeinsamen Ebene 6 angeordnet. Dadurch umfassen die normale Einheit B2 und die redundante Einheit RB2 jeweils Speicherzellen von Speicherzellenfeldern, die jeweils in gleichen Ebenen angeordnet sind.

Figur 3 zeigt eine Ausführungsform einer Redundanzschaltung 20, in der die Fuse-Bänke 21 und 22 aus Figur 2 enthalten sind. Im Betrieb des Halbleiterspeichers wird im Zuge eines Speicherzugriffs die zu ersetzende normale Einheit B2 durch die redundante Einheit RB2 adressenmäßig ersetzt. Zu Beginn eines Speicherzugriffs wird eine Redundanzauswertung in der Redundanzschaltung 20 durchgeführt. Dazu wird eine Adresse der ausgewählten normalen Einheit B2 auf dem Adreßbus ADR angelegt, woraufhin ein Vergleich der angelegten Adresse mit in den Fuse-Bänken 21 und 22 gespeicherten Adressen von defekten normalen Einheiten erfolgt. Im Beispiel ist die Adresse der normalen Einheit B2 in der Fuse-Bank 21 gespeichert. Bei einer Übereinstimmung der auf dem Adreßbus ADR anliegenden Adresse mit der in der Fuse-Bank 21 gespeicherten Adresse wird die redundante Einheit RB2 ausgewählt, die normale Einheit B2 wird deaktiviert. Ebenso wird bei einer entsprechenden Übereinstimmung mit den Einheiten RB1 beziehungsweise B1 verfahren.

## Patentansprüche

1. Integrierter Halbleiterspeicher
- mit Speicherzellen (MC, RMC), die jeweils in mehreren Speicherzellenfeldern (31 bis 36, 41 bis 46) angeordnet sind,
- bei dem die Speicherzellenfelder (31 bis 36, 41 bis 46) auf einem Halbleiterchip (10) jeweils in übereinander verlaufenden Ebenen (1 bis 6) angeordnet sind,
- bei dem mehrere der Speicherzellen (MC) zu normalen Einheiten (B1, B2) von Speicherzellen zusammengefaßt sind,
- bei dem mehrere der Speicherzellen (RMC) zu redundanten Einheiten (RB1, RB2) von Speicherzellen zum Ersetzen jeweils einer der normalen Einheiten (B1, B2) zusammengefaßt sind,
- bei dem die normalen Einheiten (B1, B2) und die redundanten Einheiten (RB1, RB2) jeweils Speicherzellen von Speicherzellenfeldern mehrerer Ebenen (1 bis 6) umfassen.

2. Integrierter Halbleiterspeicher nach Anspruch 1,
**dadurch gekennzeichnet, daß**
eine der normalen Einheiten (B2) und eine der redundanten Einheiten (RB2) jeweils Speicherzellen (MC) von Speicherzellenfeldern (34 bis 36; 44 bis 46) umfassen, die jeweils in gleichen Ebenen (4 bis 6) angeordnet sind.

3. Integrierter Halbleiterspeicher nach Anspruch 1 oder 2,
**dadurch gekennzeichnet, daß**
- der Halbleiterspeicher eine Redundanzschaltung (20) aufweist zur Auswahl einer der redundanten Einheiten (RB2) und zur Deaktivierung einer zu ersetzenden normalen Einheit (B2),
- die Redundanzschaltung (20) eine Speichereinheit (21) aufweist zum Speichern einer Adresse der durch die eine der redundanten Einheiten (RB2) zu ersetzenden normalen Einheit (B2).

4. Integrierter Halbleiterspeicher nach Anspruch 3,
**dadurch gekennzeichnet, daß**
die Speichereinheit (21) programmierbare Elemente in Form von Laser Fuses aufweist.

5. Integrierter Halbleiterspeicher nach einem der Ansprüche 1 bis 4,
**dadurch gekennzeichnet, daß**
die Speicherzellen (MC, RMC) einen magnetoresistiven Speichereffekt aufweisen und jeweils zwischen eine von mehreren Spaltenleitungen (BL, RBL) und eine von mehreren Zeilenleitungen (WL, RWL) des jeweiligen Speicherzellenfeldes geschaltet sind.

6. Verfahren zur Reparatur eines integrierten Halbleiterspeichers nach einem der vorhergehenden Ansprüche,
- bei dem die Speicherzellen (MC) der einzelnen Speicherzellenfelder auf Fehlerfreiheit geprüft werden,
- bei dem Speicherzellen (MC), die als fehlerhaft erkannt sind, durch redundante Speicherzellen (RMC) ersetzt werden,
- bei dem im Falle wenigstens einer als fehlerhaft erkannten Speicherzelle (MC1) die betreffende normale Einheit (B2), in der die als fehlerhaft erkannte Speicherzelle (MC1) enthalten ist, durch eine der redundanten Einheiten (RB2) ersetzt wird.

7. Verfahren nach Anspruch 6,
**dadurch gekennzeichnet, daß**
eine Speicherzelle (MC1) eines ersten Speicherzellenfeldes (35) durch eine redundante Speicherzelle (RMC) eines der Speicherzellenfelder (45) ersetzt wird, das in der gleichen Ebene (5) wie das erste Speicherzellenfeld (35) angeordnet ist.
